# EUROPÄISCHE PATENTSCHRIFT

(11) **EP 3 542 603 B1**
(45) Veröffentlichungstag und Bekanntmachung des Hinweises auf die Patenterteilung: **06.01.2021**
(21) Anmeldenummer: 17798196.6
(22) Anmeldetag: 15.11.2017
(51) Int. Cl.: H05K 3/46, H01R 13/6466, H01R 13/6469, H05K 1/02

(54) **ELEKTRISCHE STECKBUCHSE**
ELECTRICAL PLUG SOCKET
FICHE ÉLECTRIQUE FEMELLE

(30) Priorität: 18.11.2016 DE 102016122222
(43) Veröffentlichungstag der Anmeldung: 25.09.2019
(73) Patentinhaber: Telegärtner Karl Gärtner GmbH, 71144 Steinenbronn (DE)
(72) Erfinder: STOLL, Ralph, 70567 Stuttgart (DE)
(74) Vertreter: Hoeger, Stellrecht & Partner Patentanwälte mbB
(86) Internationale Anmeldenummer: PCT/EP2017/079276
(87) Internationale Veröffentlichungsnummer: WO 2018/091503

(56) Entgegenhaltungen:
- WO-A1-2013/181494
- GB-A- 2 280 547
- US-A- 5 800 575
- US-A1- 2012 034 822

## Beschreibung

Die Erfindung betrifft eine elektrische Steckbuchse mit einem Gehäuse, das einen Steckerschacht zum Einführen eines Verbindungssteckers aufweist, wobei im Gehäuse ein Kontaktmodul angeordnet ist mit einer verpressten mehrlagigen Leiterplattenanordnung, an der Kontaktelemente fixiert sind, die von zugeordneten Steckkontakten des Verbindungssteckers kontaktierbar sind, und wobei die verpresste mehrlagige Leiterplattenanordnung eine dielektrische Stabilisierungsschicht aufweist und oberhalb und/oder unterhalb der Stabilisierungsschicht eine Schichtanordnung positioniert ist mit einer dielektrischen Trägerschicht, die zwischen einer äußeren Leiterbahnschicht und einer inneren Leiterbahnschicht positioniert ist, wobei die Schichtanordnung mindestens einen Plattenkondensator ausbildet.

Derartige elektrische Steckbuchsen sind aus der WO 2013/181494 A1 bekannt. Sie finden in der Nachrichten- und Datentechnik eine breite Anwendung. Durch das Zusammenwirken der Steckbuchse mit einem korrespondierenden Verbindungsstecker kann beispielsweise zwischen einem ersten elektrischen Verbindungskabel und einem zweiten elektrischen Verbindungskabel eine lösbare elektrische Steckverbindung hergestellt werden zur Übertragung elektrischer Signale. Aufgrund zunehmend höherer Übertragungsraten besteht bei der Signalübertragung die Gefahr, dass sich innerhalb der Steckverbindung störende elektrische Signalkopplungen ausbilden, die die Übertragungsqualität der Signalübertragung beeinträchtigen. Um derartigen Signalkopplungen entgegenzuwirken, ist im Gehäuse der Steckbuchse ein Kontaktmodul angeordnet mit einer mehrlagigen Leiterplattenanordnung. An der Leiterplattenanordnung sind Kontaktelemente fixiert, die von zugeordneten Steckkontakten des in den Steckerschacht des Gehäuses einführbaren Verbindungssteckers kontaktierbar sind. Die Leiterplattenanordnung weist mindestens eine Schichtanordnung auf mit einer dielektrischen Trägerschicht, die zwischen einer äußeren Leiterbahnschicht und einer inneren Leiterbahnschicht positioniert ist. Die äußere Leiterbahnschicht und die innere Leiterbahnschicht weisen Leiterbahnen auf zur Übertragung elektrischer Signale. Die mindestens eine Schichtanordnung bildet mindestens einen Plattenkondensator aus, über den die äußere Leiterbahnschicht kapazitiv mit der inneren Leiterbahnschicht gekoppelt ist. Der Plattenkondensator weist Kondensatorplatten auf, die von einander gegenüberliegenden Leiterbahnbereichen der äußeren und der inneren Leiterbahnschicht gebildet werden. Das zwischen den beiden Kondensatorplatten angeordnete Dielektrikum des Plattenkondensators wird von dem zwischen den beiden Leiterbahnbereichen angeordneten Bereich der Trägerschicht gebildet. Durch den Einsatz des mindestens einen Plattenkondensators kann störenden elektrischen Signalkopplungen innerhalb der Steckbuchse entgegengewirkt werden. Die Kapazität des Plattenkondensators ist abhängig vom Abstand der einander gegenüberliegenden Leiterbahnbereiche der Leiterbahnschichten, von der Größe der Leiterbahnbereiche und auch von der Dielektrizitätskonstante der Trägerschicht.

Der Aufbau von Leiterplattenanordnungen mit mehr als zwei Leiterbahnschichten erfolgt üblicherweise derart, dass mehrere Schichtanordnungen, die jeweils zwei Leiterbahnschichten und eine zwischen den beiden Leiterbahnschichten angeordnete dielektrische Trägerschicht aufweisen, unter Zwischenlage von mindestens einer weiteren dielektrischen Trägerschicht übereinander angeordnet werden.

Üblicherweise kommen als dielektrische Trägerschichten, die zwischen zwei Leiterbahnschichten angeordnet sind, sogenannte Prepreg-Schichten zum Einsatz. Prepreg-Schichten bestehen häufig aus einem Glasfasergewebe, das mit Epoxidharz getränkt ist. Die an ihrer Ober- und/oder Unterseite mit Leiterbahnschichten versehenen Pregreg-Schichten werden üblicherweise mit weiteren Schichten unter Wärmezufuhr zu mehrlagigen Leiterbahnanordnungen verpresst. Vor dem Verpressen ist das Epoxidharz der Prepreg-Schichten nur angehärtet, aber noch nicht vollständig ausgehärtet. Dies verleiht den Prepreg-Schichten eine gewisse Verformbarkeit. Das Epoxidharz bildet ein Bindemittel aus, das sich mit den weiteren Schichten beim Verpressen verbindet und dadurch die Prepreg-Schichten an den weiteren Schichten fixiert.

Das Verpressen von Prepreg-Schichten hat zur Folge, dass sich deren Materialstärke ungleichmäßig verändert. Falls die Prepreg-Schichten zwischen zwei Leiterbahnschichten angeordnet sind, so verringert sich durch das Verpressen der Abstand zwischen den Leiterbahnschichten, da die Leiterbahnschichten in die Prepreg-Schichten hineingepresst werden. Die daraus resultierende Verdichtung und Verdrängung des Prepregmaterials beeinflusst auch die Dielektrizitätskonstante in nicht vorhersehbarer Weise. Diese Veränderungen führen dazu, dass sich die Kapazitätswerte von Plattenkondensatoren verändern, die von einander gegenüberliegenden Leiterbahnbereichen der Leiterbahnschichten und dem dielektrischen Material der Prepreg-Schichten gebildet werden. Wie bereits erwähnt, ist für den Wert der Kapazität der Plattenkondensatoren neben der Größe der Kondensatorplatten und der Dielektrizitätskonstante des Dielektrikums der Abstand zwischen den Kondensatorplatten entscheidend. Der Abstand zwischen den Kondensatorplatten wird in der üblichen Ausführung mehrlagiger Leiterplattenanordnungen durch die Materialstärke der Prepreg-Schichten bestimmt. Die Materialstärke, die eine Prepreg-Schicht nach dem Verpressen einnimmt, ist mit erheblichen Toleranzen behaftet, so dass ein optimaler Kapazitätswert oft nur mit großen Streuungen erreicht werden kann. Auch die Dielektrizitätskonstante der Prepreg-Schichten ist häufig mit Inhomogenitäten behaftet, die ihre Ursache in der unterschiedlichen räumlichen Verteilung von Epoxidharz und Fasergewebe nach dem Verpressen der Schichten haben. In der EP 1 602 263 B1 wird deshalb vorgeschlagen, nach dem Verpressen einer mehrlagigen Leiterplattenanordnung frequenzabhängige Parameter der Leiterplattenanordnung zu bestimmen und auszuwerten, so dass für eine optimale Übertragungsqualität geeignete Leiterplattenanordnungen aus einer Fertigungscharge ausgewählt werden können. Dies hat allerdings den Nachteil, dass ein nicht definierbarer Anteil der Fertigungscharge aussortiert und allenfalls für Applikationen mit geringeren Anforderungen an die Übertragungsqualität verwendet werden kann. Hinzu kommt ein erheblicher Zeit- und Kostenaufwand für die notwendige Automatisierung der Messungen und Auswertungen.

Aufgabe der Erfindung ist es daher, eine elektrische Steckbuchse der eingangs genannten Art derart weiterzubilden, dass fertigungsbedingte Schwankungen des Kapazitätswerts des mindestens einen Plattenkondensators gering gehalten werden können.

Diese Aufgabe wird bei einer elektrischen Steckbuchse der gattungsgemäßen Art erfindungsgemäß dadurch gelöst, dass die Trägerschicht der Schichtanordnung ein bereits vor dem Verpressen der mehrlagigen Leiterplattenanordnung ausgehärtetes faserverstärktes Harz aufweist und zwischen der Schichtanordnung und der Stabilisierungsschicht mindestens eine Prepreg-Schicht angeordnet ist zur Fixierung der Schichtanordnung an der Stabilisierungsschicht.

Bei der erfindungsgemäßen elektrischen Steckbuchse kommt ein Kontaktmodul mit einer mehrlagigen Leiterplattenanordnung zum Einsatz, die eine dielektrische Stabilisierungsschicht aufweist. Oberhalb und/oder unterhalb der Stabilisierungsschicht ist eine Schichtanordnung positioniert. Die Schichtanordnung weist eine dielektrische Trägerschicht auf, die zwischen einer äußeren und einer inneren Leiterbahnschicht positioniert ist. Die dielektrische Stabilisierungsschicht verleiht der Leiterplattenanordnung eine hohe mechanische Stabilität und erleichtert dadurch das Fixieren von Kontaktelementen an der Leiterplattenanordnung. Die dielektrische Trägerschicht der mindestens einen Schichtanordnung weist erfindungsgemäß ein bereits vor dem Verpressen der mehrlagigen Leiterplattenanordnung ausgehärtetes faserverstärktes Harz auf. Die Fixierung der mindestens einen Schichtanordnung an der dielektrischen Stabilisierungsschicht erfolgt mit Hilfe von mindestens einer Prepreg-Schicht.

Zur Herstellung der mehrlagigen Leiterplattenanordnung kann die ausgehärtete Trägerschicht oberseitig und unterseitig mit einer Leiterbahnschicht versehen werden, und anschließend kann die Trägerschicht unter Zwischenlage von mindestens einer Prepreg-Schicht mit der dielektrischen Stabilisierungsschicht unter Wärmezufuhr verpresst werden. Durch das Verpressen verbindet sich das als Bindemittel vorgesehene Epoxidharz der Prepreg-Schicht mit der Trägerschicht und der Stabilisierungsschicht und fixiert dadurch die Schichtanordnung an der Stabilisierungsschicht.

Beim Verpressen kann sich die Materialstärke der Prepreg-Schicht verändern, wohingegen sich die Materialstärke und die Dielektrizitätskonstante der bereits vor dem Verpressen ausgehärteten Trägerschicht praktisch nicht verändern. Somit führt das Verpressen der mehrlagigen Leiterplattenanordnung praktisch zu keiner Änderung des Kapazitätswertes des mindestens einen Plattenkondensators, der von Leiterbahnbereichen der äußeren und der inneren Leiterbahnschicht und der dielektrischen Trägerschicht gebildet wird. Fertigungsbedingte Schwankungen des Kapazitätswertes des mindestens einen Plattenkondensators können somit gering gehalten werden.

Es kann vorgesehen sein, dass die mehrlagige Leiterplattenanordnung lediglich eine einzige Schichtanordnung aufweist, die auf der Oberseite oder auf der Unterseite der Stabilisierungsschicht unter Zwischenlage von mindestens einer Prepreg-Schicht positioniert ist. Bei einer derartigen Ausgestaltung weist die mehrlagige Leiterplattenanordnung lediglich eine einzige äußere Leiterbahnschicht und eine einzige innere Leiterbahnschicht auf. Die äußere Leiterbahnschicht ist auf der der Stabilisierungsschicht abgewandten Oberseite der Trägerschicht angeordnet, und die untere Leiterbahnschicht ist auf der der Stabilisierungsschicht zugewandten Unterseite der Trägerschicht angeordnet. Zur Herstellung der mehrlagigen Leiterbahnanordnung können die zwischen zwei Leiterbahnschichten angeordnete Trägerschicht, die mindestens eine Prepreg-Schicht und die Stabilisierungsschicht aufeinander gestapelt und anschließend unter Wärmezufuhr miteinander verpresst werden.

Von besonderem Vorteil ist es, wenn die mehrlagige Leiterplattenanordnung zwei Schichtanordnungen aufweist, wobei eine erste Schichtanordnung unter Zwischenlage von mindestens einer ersten Prepreg-Schicht an der Oberseite der Stabilisierungsschicht positioniert ist, und wobei eine zweite Schichtanordnung unter Zwischenlage von mindestens einer zweiten Prepreg-Schicht an der Unterseite der Stabilisierungsschicht positioniert ist. Die Stabilisierungsschicht bildet bei einer derartigen Ausgestaltung einen zentralen dielektrischen Kern der mehrlagigen Leiterplattenanordnung aus, der sowohl auf seiner Oberseite als auch auf seiner Unterseite eine Schichtanordnung trägt mit einer äußeren und einer inneren Leiterbahnschicht, zwischen denen eine dielektrische Trägerschicht positioniert ist. Bei einer derartigen Ausgestaltung weist die mehrlagige Leiterplattenanordnung somit insgesamt vier Leiterbahnschichten auf. Zur Herstellung der mehrlagigen Leiterbahnanordnung können eine erste Trägerschicht, die zwischen zwei Leiterbahnschichten angeordnet ist, eine erste Prepreg-Schicht, die Stabilisierungsschicht, eine zweite Prepreg-Schicht und eine zweite Trägerschicht, die zwischen zwei Leiterbahnschichten angeordnet ist, aufeinander gestapelt und unter Wärmezufuhr miteinander verpresst werden.

Die Stabilisierungsschicht weist vorteilhafterweise ein bereits vor dem Verpressen der mehrlagigen Leiterbahnanordnung ausgehärtetes faserverstärktes Harz auf. Dies hat den Vorteil, dass sich die Materialstärke der Stabilisierungsschicht beim Verpressen der mehrlagigen Leiterplattenanordnung praktisch nicht ändert.

Insbesondere kann vorgesehen sein, dass die Stabilisierungsschicht ein bereits vor dem Verpressen der mehrlagigen Leiterbahnanordnung ausgehärtetes faserverstärktes Epoxidharz aufweist, beispielsweise ein bereits vor dem Verpressen der mehrlagigen Leiterbahnanordnung ausgehärtetes glasfaserverstärktes Epoxidharz. Insbesondere kann die Stabilisierungsschicht aus einem bereits vor dem Verpressen der mehrlagigen Leiterbahnanordnung ausgehärteten glasfaserverstärkten Epoxidharz bestehen.

Von Vorteil ist es, wenn die Stabilisierungsschicht eine Materialstärke von mindestens 75 µm aufweist, insbesondere eine Materialstärke von 75 µm bis 1,2 mm. Eine derartige Materialstärke verleiht der Stabilisierungsschicht eine hohe mechanische Stabilität. Trägt die Stabilisierungsschicht sowohl auf ihrer Oberseite als auch auf ihrer Unterseite eine Schichtanordnung mit einem Paar von Leiterbahnschichten, so ist durch die genannte Materialstärke darüber hinaus sichergestellt, dass sich die Paare der Leiterbahnschichten gegenseitig nicht kapazitiv oder induktiv beeinflussen.

Wie bereits erwähnt, weist die Trägerschicht der mindestens einen Schichtanordnung ein bereits vor dem Verpressen der mehrlagigen Leiterbahnanordnung ausgehärtetes faserverstärktes Harz auf. Insbesondere kann vorgesehen sein, dass die Trägerschicht ein bereits vor dem Verpressen der mehrlagigen Leiterbahnanordnung ausgehärtetes faserverstärktes Epoxidharz aufweist, beispielsweise ein bereits vor dem Verpressen der mehrlagigen Leiterbahnanordnung ausgehärtetes glasfaserverstärktes Epoxidharz. Insbesondere kann die Trägerschicht aus einem bereits vor dem Verpressen der mehrlagigen Leiterbahnanordnung ausgehärteten glasfaserverstärkten Epoxidharz bestehen.

Von Vorteil ist es, wenn die Trägerschicht der mindestens einen Schichtanordnung eine Materialstärke von mindestens 75 µm aufweist, insbesondere eine Materialstärke von 75 µm bis 1,2 mm.

Die mindestens eine Prepreg-Schicht, die zwischen einer Schichtanordnung und der Stabilisierungsschicht positioniert ist, weist nach dem Verpressen der mehrlagigen Leiterplattenanordnung bevorzugt eine Materialstärke von mindestens 40 µm auf, insbesondere eine Materialstärke von 40 µm bis 180 µm.

Bei einer vorteilhaften Ausgestaltung der Erfindung bilden die äußere Leiterbahnschicht und die Trägerschicht der mindestens einen Schichtanordnung gemeinsam eine vorgefertigte, einseitig beschichtete Leiterplatte aus, und die innere Leiterbahnschicht der mindestens einen Schichtanordnung und eine an der inneren Leiterbahnschicht anliegende Prepreg-Schicht bilden gemeinsam eine vorgefertigte, einseitig beschichtete Prepreg-Schichtanordnung aus. Bei einer derartigen Ausgestaltung werden vor dem Verpressen der mehrlagigen Leiterplattenanordnung zunächst eine einseitig beschichtete Leiterplatte und eine einseitig beschichtete Prepreg-Schicht hergestellt. Anschließend können die einseitig beschichtete Leiterplatte, die einseitig beschichtete Prepreg-Schicht und die Stabilisierungsschicht aufeinandergestapelt und unter Wärmezufuhr miteinander verpresst werden. Es kann auch vorgesehen sein, dass eine erste Leiterplatte, die auf ihrer Oberseite beschichtet ist, eine erste Prepreg-Schicht, die auf ihrer Oberseite beschichtet ist, die Stabilisierungsschicht, eine zweite Prepreg-Schicht, die auf ihrer Unterseite beschichtet ist, und eine zweite Leiterplatte, die auf ihrer Unterseite beschichtet ist, aufeinander gestapelt und unter Wärmezufuhr miteinander verpresst werden.

Bei einer alternativen Ausgestaltung der Erfindung bilden die äußere Leiterplattenschicht, die Trägerschicht und die innere Leiterbahnschicht der mindestens einen Schichtanordnung eine vorgefertigte, beidseitig beschichtete Leiterplatte aus. Die beidseitig beschichtete Leiterplatte, mindestens eine unbeschichtete Prepreg-Schicht und die Stabilisierungsschicht können aufeinandergestapelt und unter Wärmezufuhr miteinander verpresst werden. Es kann auch vorgesehen sein, dass eine erste beidseitig beschichtete Leiterplatte, mindestens eine erste unbeschichtete Prepreg-Schicht, die Stabilisierungsschicht, mindestens eine zweite unbeschichtete Prepreg-Schicht und eine zweite beidseitig beschichtete Leiterplatte aufeinander gestapelt und unter Wärmezufuhr miteinander verpresst werden.

Der Einsatz von mindestens einer Schichtanordnung, bei der eine äußere Leiterplattenschicht, eine dielektrische Trägerschicht und eine innere Leiterbahnschicht eine vorgefertigte, beidseitig beschichtete Leiterplatte ausbilden, hat unter anderem den Vorteil, dass sich die an der gemeinsamen Trägerschicht festgelegten Leiterbahnschichten beim Verpressen der mehrlagigen Leiterplattenanordnung praktisch nicht parallel zueinander verschieben. Es bildet sich somit praktisch kein Versatz der Leiterbahnschichten zueinander aus. Dies wiederum hat den Vorteil, dass sich die relative Lage der von einander gegenüberliegenden Leiterbahnbereichen der Leiterbahnschichten gebildeten Kondensatorplatten durch das Verpressen der Leiterplattenanordnung praktisch nicht ändert.

Die nachfolgende Beschreibung vorteilhafter Ausführungsformen der Erfindung dient im Zusammenhang mit der Zeichnung der näheren Erläuterung. Es zeigen:
- Figur 1:: eine perspektivische Darstellung einer elektrischen Steckbuchse;
- Figur 2:: eine perspektivische Darstellung der elektrischen Steckbuchse aus Figur 1 nach Art einer Explosionszeichnung;
- Figur 3:: eine perspektivische Darstellung eines Teilbereichs einer verpressten mehrlagigen Leiterplattenanordnung der elektrischen Steckbuchse aus Figur 1;
- Figur 4:: eine perspektivische Darstellung des Teilbereichs der Leiterplattenanordnung aus Figur 3 nach Art einer Explosionszeichnung;
- Figur 5:: eine Seitenansicht des Teilbereichs der Leiterplattenanordnung aus Figur 3 nach Art einer Explosionszeichnung;
- Figur 6:: eine perspektivische Darstellung eines Teilbereichs einer alternativen Ausgestaltung einer Leiterplattenanordnung der elektrischen Steckbuchse aus Figur 1 nach Art einer Explosionszeichnung;
- Figur 7:: eine Seitenansicht des Teilbereichs der Leiterplattenanordnung aus Figur 6 nach Art einer Explosionszeichnung.

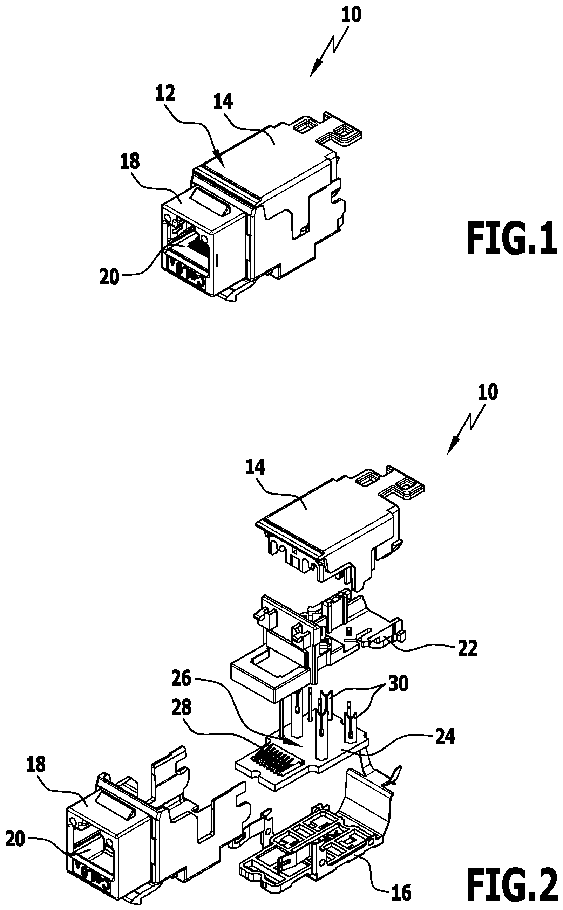

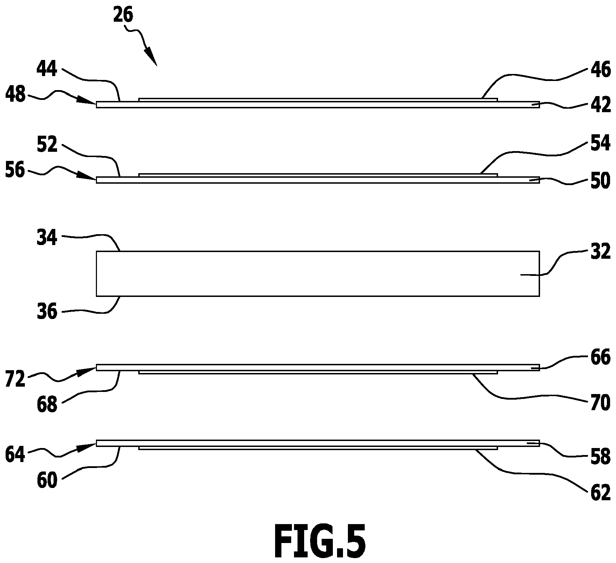

In den Figuren 1 bis 5 ist eine vorteilhafte Ausführungsform einer erfindungsgemäßen elektrischen Steckbuchse schematisch dargestellt und insgesamt mit dem Bezugszeichen 10 belegt. Die Steckbuchse 10 weist ein mehrteiliges Gehäuse 12 auf mit einem Gehäuseoberteil 14, einem Gehäuseunterteil 16 und einem Gehäusekopfteil 18. Das Gehäusekopfteil 18 weist einen Steckerschacht 20 auf, in den ein komplementär ausgestalteter Verbindungsstecker eingeführt werden kann zur Herstellung einer elektrischen Verbindung, über die elektrische Signale übertragen werden können. Derartige Verbindungsstecker sind dem Fachmann an sich bekannt und bedürfen daher vorliegend keiner näheren Erläuterung.

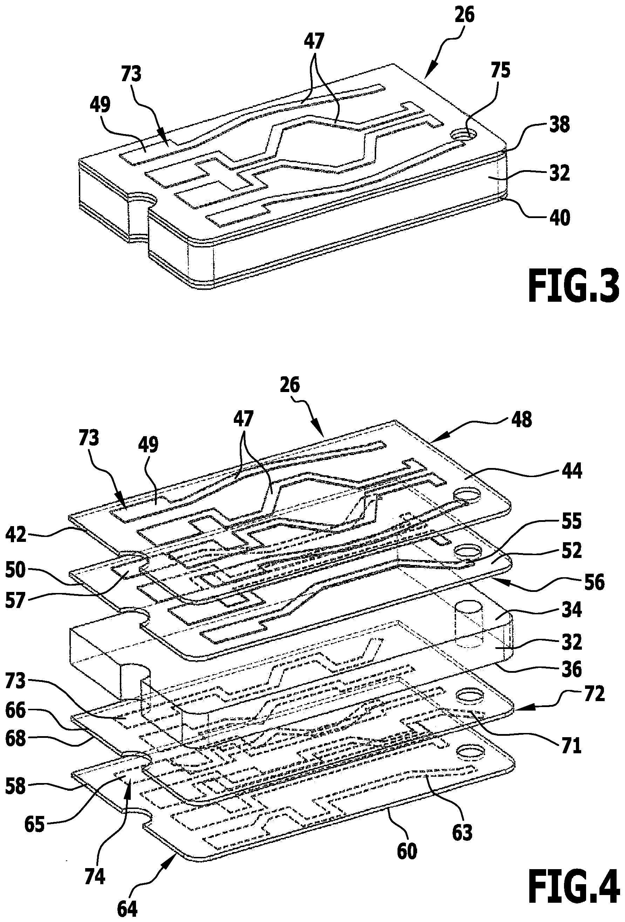

Innerhalb des Gehäuses 12 sind ein Zwischenteil 22 und ein Kontaktmodul 24 angeordnet. Das Kontaktmodul 24 weist eine in den Figuren 3 bis 5 schematisch dargestellte mehrlagige Leiterplattenanordnung 26 auf, an der Kontaktelemente in Form von Federzungen 28 sowie Anschlusselemente 30 festgelegt sind. Die Federzungen 28 tauchen in den Steckerschacht 20 ein und können von zugeordneten Steckkontakten des Verbindungssteckers kontaktiert werden. Die Anschlusselemente 30 weisen Schneid-Klemmkontakte auf und sind in einem dem Steckerschacht 20 abgewandten rückwärtigen Bereich der Leiterplattenanordnung 26 angeordnet. An die Anschlusselemente 30 kann jeweils eine Ader eines Verbindungskabels angeschlossen werden. Derartige Verbindungskabel sind dem Fachmann an sich bekannt und deshalb in der Zeichnung zur Erzielung einer besseren Übersicht nicht dargestellt.

Die mehrlagige Leiterplattenanordnung 26 weist eine zentrale Stabilisierungsschicht 32 auf mit einer Oberseite 34 und einer Unterseite 36. Oberhalb der Stabilisierungsschicht 32 ist eine erste Schichtanordnung 38 positioniert, und unterhalb der Stabilisierungsschicht 32 ist eine zweite Schichtanordnung 40 positioniert. Dies wird insbesondere aus Figur 3 deutlich.

Die erste Schichtanordnung 38 weist eine erste Trägerschicht 42 auf, die zwischen einer ersten äußeren Leiterbahnschicht 46 und einer ersten inneren Leiterbahnschicht 54 angeordnet ist. Die erste äußere Leiterbahnschicht 46 und die erste innere Leiterbahnschicht 54 weisen jeweils eine Vielzahl von Leiterbahnen 47 beziehungsweise 55 auf. Die erste Trägerschicht 42 bildet in Kombination mit der ersten äußeren Leiterbahnschicht 46 eine erste vorgefertigte, einseitig beschichtete Leiterplatte 48 aus.

Zwischen der ersten Schichtanordnung 38 und der Stabilisierungsschicht 32 ist eine erste Prepreg-Schicht 50 angeordnet, die auf ihrer Oberseite 52 mit der ersten inneren Leiterbahnschicht 54 beschichtet ist. Die erste Prepreg-Schicht 50 und die erste innere Leiterbahnschicht 54 bilden gemeinsam eine erste vorgefertigte, einseitig beschichtete Prepreg-Schichtanordnung 56 aus.

Die zweite Schichtanordnung 40 weist eine zweite Trägerschicht 58 auf, die zwischen einer zweiten äußeren Leiterbahnschicht 62 und einer zweiten inneren Leiterbahnschicht 70 angeordnet ist. Die zweite äußere Leiterbahnschicht 62 und die zweite innere Leiterbahnschicht 70 weisen eine Vielzahl von Leiterbahnen 63 beziehungsweise 71 auf. Die zweite Trägerschicht 58 bildet in Kombination mit der zweiten äußeren Leiterbahnschicht 62 eine zweite vorgefertigte, einseitig beschichtete Leiterplatte 64 aus.

Zwischen der zweiten Schichtanordnung 40 und der Stabilisierungsschicht 32 ist eine zweite Prepreg-Schicht 66 angeordnet, die auf ihrer der Stabilisierungsschicht 32 abgewandten Unterseite 68 die zweite innere Leiterbahnschicht 70 trägt. Die zweite Prepreg-Schicht 66 und die zweite innere Leiterbahnschicht 70 bilden gemeinsam eine zweite vorgefertigte, einseitig beschichtete Prepreg-Schichtanordnung 72 aus.

Die Stabilisierungsschicht 32 besteht aus einem bereits vor dem Verpressen der Leiterplattenanordnung 26 ausgehärteten faserverstärkten Harz, insbesondere aus einem bereits vor dem Verpressen der Leiterplattenanordnung 26 ausgehärteten glasfaserverstärkten Epoxidharz, und weist eine Materialstärke von mindestens 75 µm auf, insbesondere eine Materialstärke im Bereich von 75 µm bis 1,2 mm.

Die erste Trägerschicht 42 und die zweite Trägerschicht 58 bestehen ebenfalls aus einem bereits vor dem Verpressen der Leiterplattenanordnung 26 ausgehärteten faserverstärkten Harz, insbesondere aus einem bereits vor dem Verpressen der Leiterplattenanordnung 26 ausgehärteten glasfaserverstärkten Epoxidharz, und weisen jeweils eine Materialstärke von mindestens 75 µm, insbesondere eine Materialstärke im Bereich von 75 µm bis 1,2 mm.

Die erste Prepreg-Schicht 50 und die zweite Prepreg-Schicht 66 bestehen aus einem Faser-Harz-Verbund, insbesondere aus einem Glasfaser-Epoxidharz-Verbund, wobei das Harz vor dem Verpressen der Leiterplattenanordnung 26 lediglich angehärtet, aber noch nicht vollständig ausgehärtet ist. Die Materialstärke der Prepreg-Schichten 50 und 66 beträgt nach dem Verpressen der Leiterplattenanordnung 26 mindestens 40 µm, insbesondere 40 µm bis 180 µm.

Zur Herstellung der mehrlagigen Leiterplattenanordnung 26 werden zunächst die vorgefertigten Leiterplatten 48 und 64 und die vorgefertigten Prepreg-Schichtanordnungen 56 und 72 hergestellt. Hierzu werden die Trägerschichten 42 und 58 jeweils einseitig mit einer Leiterbahnschicht versehen, und die Prepreg-Schichten 50 und 66 werden ebenfalls jeweils einseitig mit einer Leiterbahnschicht versehen. Anschließend werden die erste vorgefertigte Leiterplatte 48, die erste vorgefertigte Prepreg-Schichtanordnung 56, die Stabilisierungsschicht 32, die zweite vorgefertigte Prepreg-Schichtanordnung 72 und die zweite vorgefertigte Leiterplatte 64 aufeinander gestapelt und unter Wärmezufuhr miteinander verpresst. Dies hat zur Folge, dass das als Bindemittel vorgesehene Harz der vorgefertigten Prepreg-Schichtanordnungen 56 und 72 die vorgefertigten Leiterplatten 48 und 64 mit der Stabilisierungsschicht 32 verbindet, so dass die erste Schichtanordnung 38 an der Oberseite 34 der Stabilisierungsschicht fixiert ist und dass die zweite Schichtanordnung 40 an der Unterseite 36 der Stabilisierungsschicht 32 fixiert ist.

Über die Leiterbahnen 47 und 63 der äußeren Leiterbahnschichten 46, 62 und über die Leiterbahnen 55 und 71 der inneren Leiterbahnschichten 54, 70 sind die Federzungen 28 mit den Anschlusselementen 30 elektrisch verbunden. Die erste äußere Leiterbahnschicht 46 und die erste innere Leiterbahnschicht 54 weisen einander gegenüberliegende Leiterbahnbereiche 49, 57 auf, die unter Zwischenlage der dielektrischen Trägerschicht 42 mindestens einen oberen Plattenkondensator 73 ausbilden. In entsprechender Weise weisen die zweite äußere Leiterbahnschicht 62 und die zweite innere Leiterbahnschicht 70 einander gegenüberliegende Leiterbahnbereiche 65, 73 auf, die unter Zwischenlage der dielektrischen zweiten Trägerschicht 58 mindestens einen unteren Plattenkondensator 74 ausbilden. Mit Hilfe der Plattenkondensatoren 73, 74 kann störenden elektrischen Signalkopplungen entgegengewirkt werden. Die Kapazitätswerte der Plattenkondensatoren 73, 74 werden durch die Größe der jeweils eine Kondensatorplatte ausbildenden, einander gegenüberliegenden Leiterbahnbereiche der Leiterbahnschichten, durch den Abstand der Kondensatorplatten und durch die Dielektrizitätskonstante der Trägerschichten 42, 58 vorgegeben. Da die Trägerschichten 42, 58 bereits vor dem Verpressen der mehrlagigen Leiterplattenanordnung 26 ausgehärtet sind, führt das Verpressen der mehrlagigen Leiterplattenanordnungen 26 zu keiner merklichen Veränderung des Abstands der äußeren Leiterbahnschichten 46 und 62 von den jeweils zugeordneten inneren Leiterbahnschichten 54 bzw. 70, so dass auch die Kapazitätswerte der Plattenkondensatoren 73, 74 durch das Verpressen der mehrlagigen Leiterplattenanordnung 26 praktisch nicht verändert werden.

Die Stabilisierungsschicht 32 verleiht der mehrlagigen Leiterplattenanordnung 26 eine hohe mechanische Stabilität, so dass die Federzungen 28 und auch die Anschlusselemente 30 nach dem Verpressen der mehrlagigen Leiterplattenanordnung 26 in Bohrungen der mehrlagigen Leiterplattenanordnung 26 eingepresst werden können, wobei in der Zeichnung zur Erzielung einer besseren Übersicht lediglich eine Bohrung 75 dargestellt ist.

Die dielektrische Stabilisierungsschicht 32 hat zusätzlich zu ihrer mechanischen Stabilisierungsfunktion auch die Wirkung, dass die erste Schichtanordnung 32 elektrisch von der zweiten Schichtanordnung 34 entkoppelt ist, das heißt die Stabilisierungsschicht 32 sorgt dafür, dass die erste Schichtanordnung 38 von der zweiten Schichtanordnung 40 elektrisch isoliert ist und auch keine merkliche kapazitive oder induktive Kopplung der Schichtanordnungen vorliegt.

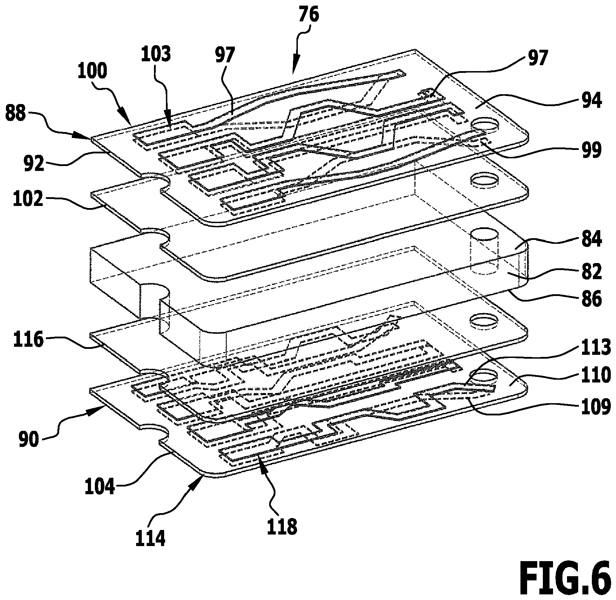

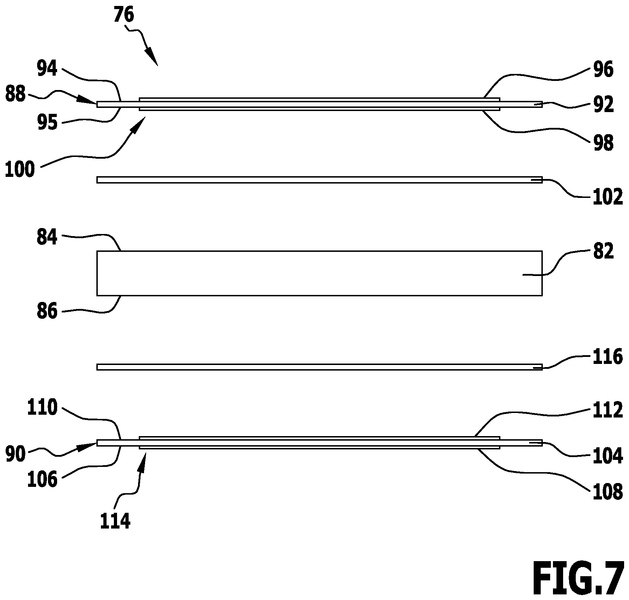

In den Figuren 6 und 7 ist eine alternative Ausgestaltung einer mehrlagigen Leiterplattenanordnung des Kontaktmoduls 24 schematisch dargestellt und insgesamt mit dem Bezugszeichen 76 belegt. Die mehrlagige Leiterplattenanordnung 76 weist eine Stabilisierungsschicht 82 auf, die identisch ausgestaltet ist wie die voranstehend unter Bezugnahme auf Figur 3 erläuterte Stabilisierungsschicht 32. Die Stabilisierungsschicht 82 weist eine Oberseite 84 und eine Unterseite 86 auf. Die Stabilisierungsschicht 82 besteht aus einem bereits vor dem Verpressen der Leiterplattenanordnung 76 ausgehärteten faserverstärkten Harz, insbesondere aus einem bereits vor dem Verpressen der Leiterplattenanordnung 76 ausgehärteten glasfaserverstärkten Epoxidharz, und weist eine Materialstärke von mindestens 75 µm auf, insbesondere eine Materialstärke von 75 µm bis 1,2 mm.

Oberhalb der Stabilisierungsschicht 82 ist eine erste Schichtanordnung 88 positioniert, und unterhalb der Stabilisierungsschicht 82 ist eine zweite Schichtanordnung 90 positioniert.

Die erste Schichtanordnung 88 weist eine erste Trägerschicht 92 auf. An der der Stabilisierungsschicht 82 abgewandten Oberseite 94 der ersten Trägerschicht 92 ist eine erste äußere Leiterbahnschicht 96 positioniert. An der der Stabilisierungsschicht 82 zugewandten Unterseite 95 der ersten Trägerschicht 92 ist eine erste innere Leiterbahnschicht 98 positioniert. Die erste äußere Leiterbahnschicht 96 und die erste innere Leiterbahnschicht 98 weisen jeweils eine Vielzahl von Leiterbahnen 97, 99 auf. Einander gegenüberliegende Leiterbahnbereiche der ersten äußeren Leiterbahnschicht 96 und der ersten inneren Leiterbahnschicht 98 bilden obere Plattenkondensatoren 103 aus. Die erste Trägerschicht 92 besteht aus einem bereits vor dem Verpressen der Leiterplattenanordnung 76 ausgehärteten faserverstärkten Harz, insbesondere aus einem bereits vor dem Verpressen der Leiterplattenanordnung 76 ausgehärteten glasfaserverstärkten Epoxidharz, und weist eine Materialstärke von mindestens 75 µm auf, insbesondere eine Materialstärke von 75 µm bis 1,2 mm.

Die erste Trägerschicht 92 bildet gemeinsam mit der ersten äußeren Leiterbahnschicht 96 und der ersten inneren Leiterbahnschicht 98 eine erste vorgefertigte, beidseitig beschichtete Leiterplatte 100 aus.

Zwischen der ersten Schichtanordnung 88 und der Stabilisierungsschicht 82 ist eine erste unbeschichtete Prepreg-Schicht 102 angeordnet.

Die zweite Schichtanordnung 90 weist eine zweite Trägerschicht 104 auf, die identisch ausgestaltet ist wie die erste Trägerschicht 92 und die auf ihrer der Stabilisierungsschicht 82 abgewandten Unterseite 106 eine zweite äußere Leiterbahnschicht 108 und auf ihrer der Stabilisierungsschicht 82 zugewandten Oberseite 110 eine zweite innere Leiterbahnschicht 112 trägt. Die zweite äußere Leiterbahnschicht 108 und die zweite innere Leiterbahnschicht 112 weisen jeweils eine Vielzahl von Leiterbahnen 109, 113 auf. Einander gegenüberliegende Leiterbahnbereiche der zweiten äußeren Leiterbahnschicht 108 und der zweiten inneren Leiterbahnschicht 112 bilden untere Plattenkondensatoren 118 aus. Die zweite Trägerschicht 104 bildet gemeinsam mit der zweiten äußeren Leiterbahnschicht 108 und der zweiten inneren Leiterbahnschicht 112 eine zweite vorgefertigte, beidseits beschichtete Leiterplatte 114 aus.

Zwischen der zweiten Schichtanordnung 90 und der Stabilisierungsschicht 82 ist eine zweite unbeschichtete Prepreg-Schicht 116 angeordnet, die identisch ausgestaltet ist wie die erste unbeschichtete Prepreg-Schicht 102 und aus einem Faser-Harz-Verbund besteht, insbesondere aus einem Glasfaser-Epoxidharz-Verbund, wobei das Harz vor dem Verpressen der Leiterplattenanordnung 76 lediglich angehärtet, aber noch nicht vollständig ausgehärtet ist.

Die Materialstärke der beiden unbeschichteten Prepreg-Schichten 102, 116 beträgt jeweils mindestens 40 µm, insbesondere 40 µm bis 180 µm.

Zur Herstellung der mehrlagigen Leiterplattenanordnung 76 werden zunächst die beiden vorgefertigten, beidseitig beschichteten Leiterplatten 100, 114 gefertigt. Die erste vorgefertigte Leiterplatte 100, die erste unbeschichtete Prepreg-Schicht 102, die Stabilisierungsschicht 82, die zweite unbeschichtete Prepreg-Schicht 116 und die zweite vorgefertigte Leiterplatte 114 werden aufeinandergestapelt und unter Wärmezufuhr miteinander verpresst. Das als Bindemittel dienende Harz der beiden unbeschichteten Prepreg-Schichten 102, 116 verbindet die vorgefertigten Leiterplatten 100, 114 mit der mittig angeordneten Stabilisierungsschicht 82. Beim Verpressen der mehrlagigen Leiterplattenanordnung 76 ändert sich daher die Materialstärke der unbeschichteten Prepreg-Schichten 102, 116. Die Materialstärke der Trägerschichten 92, 104 wird dagegen beim Verpressen der mehrlagigen Leiterplattenanordnung 76 praktisch nicht verändert. Dies hat zur Folge, dass sich der Abstand der ersten äußeren Leiterbahnschicht 96 zur ersten inneren Leiterbahnschicht 98 beim Verpressen der mehrlagigen Leiterplattenanordnung 76 praktisch nicht verändert, und dass sich auch der Abstand der zweiten äußeren Leiterbahnschicht 108 zur zweiten inneren Leiterbahnschicht 112 beim Verpressen der mehrlagigen Leiterplattenanordnung 76 praktisch nicht verändert. Dies wiederum stellt sicher, dass sich die Kapazitätswerte der Plattenkondensatoren 103, 118, die von einander gegenüberliegenden Leiterbahnbereichen der beidseitig beschichteten Leiterplatten 100, 114 gebildet werden, durch das Verpressen der mehrlagigen Leiterplattenanordnung 76 praktisch nicht verändern.

## Patentansprüche

1. Elektrische Steckbuchse mit einem Gehäuse (12), das einen Steckerschacht (20) zum Einführen eines Verbindungssteckers aufweist, wobei im Gehäuse (12) ein Kontaktmodul (24) angeordnet ist mit einer verpressten mehrlagigen Leiterplattenanordnung (26, 76), an der Kontaktelemente (28) fixiert sind, die von zugeordneten Steckkontakten des Verbindungssteckers kontaktierbar sind, und wobei die verpresste mehrlagige Leiterplattenanordnung (26, 76) eine dielektrische Stabilisierungsschicht (32, 82) aufweist und oberhalb und/oder unterhalb der Stabilisierungsschicht (32, 82) eine Schichtanordnung (38, 40, 88, 90) positioniert ist mit einer dielektrischen Trägerschicht (42, 58, 92, 104), die zwischen einer äußeren Leiterbahnschicht (46, 62, 96, 108) und einer inneren Leiterbahnschicht (54, 70, 98, 112) positioniert ist, wobei die Schichtanordnung (38, 40, 88, 90) mindestens einen Plattenkondensator (73, 74, 103, 118) ausbildet, **dadurch gekennzeichnet, dass** die Trägerschicht (42, 58, 92, 104) der Schichtanordnung (38, 40, 88, 90) ein bereits vor dem Verpressen der mehrlagigen Leiterplattenanordnung (26, 76) ausgehärtetes faserverstärktes Harz aufweist und zwischen der Schichtanordnung (38, 40, 88, 90) und der Stabilisierungsschicht (32, 82) mindestens eine Prepreg-Schicht (50, 66, 102, 116) angeordnet ist zur Fixierung der Schichtanordnung (38, 40, 88, 90) an der Stabilisierungsschicht (32, 82).

2. Elektrische Steckbuchse nach Anspruch 1, **dadurch gekennzeichnet, dass** die Stabilisierungsschicht (32, 82) ein bereits vor dem Verpressen der mehrlagigen Leiterplattenanordnung (26, 76) ausgehärtetes faserverstärktes Harz aufweist.

3. Elektrische Steckbuchse nach Anspruch 2, **dadurch gekennzeichnet, dass** die Stabilisierungsschicht (32, 82) ein bereits vor dem Verpressen der mehrlagigen Leiterplattenanordnung (26, 76) ausgehärtetes faserverstärktes Epoxidharz aufweist, insbesondere ein bereits vor dem Verpressen der mehrlagigen Leiterplattenanordnung (26, 76) ausgehärtetes glasfaserverstärktes Epoxidharz.

4. Elektrische Steckbuchse nach Anspruch 1, 2 oder 3, **dadurch gekennzeichnet, dass** die Stabilisierungsschicht (32, 82) eine Materialstärke von mindestens 75 µm aufweist, insbesondere eine Materialstärke von 75 µm bis 1,2 mm.

5. Elektrische Steckbuchse nach einem der voranstehenden Ansprüche, **dadurch gekennzeichnet, dass** die Trägerschicht (42, 58, 92, 104) der mindestens einen Schichtanordnung (38, 40, 88, 90) ein bereits vor dem Verpressen der mehrlagigen Leiterplattenanordnung (26, 76) ausgehärtetes faserverstärktes Epoxidharz aufweist, insbesondere ein bereits vor dem Verpressen der mehrlagigen Leiterplattenanordnung (26, 76) ausgehärtetes glasfaserverstärktes Epoxidharz.

6. Elektrische Steckbuchse nach einem der voranstehenden Ansprüche, **dadurch gekennzeichnet, dass** die Trägerschicht (42, 58, 92, 104) der mindestens einen Schichtanordnung (38, 40, 88, 90) eine Materialstärke von mindestens 75 µm aufweist, insbesondere eine Materialstärke von 75 µm bis 1,2 mm.

7. Elektrische Steckbuchse nach einem der voranstehenden Ansprüche, **dadurch gekennzeichnet, dass** die mindestens eine Prepreg-Schicht (50, 66, 102, 116) nach dem Verpressen der mehrlagigen Leiterplattenanordnung (26, 76) eine Materialstärke von mindestens 40 µm aufweist, insbesondere eine Materialstärke von 40 µm bis 180 µm.

8. Elektrische Steckbuchse nach einem der voranstehenden Ansprüche, **dadurch gekennzeichnet, dass** die äußere Leiterbahnschicht (46, 62) und die Trägerschicht (42, 58) der mindestens einen Schichtanordnung (38, 40) gemeinsam eine vorgefertigte, einseitig beschichtete Leiterplatte (48, 64) ausbilden, und dass die innere Leiterbahnschicht (54, 70) der mindestens einen Schichtanordnung (38, 40) und eine an der inneren Leiterbahnschicht (54, 70) anliegende Prepreg-Schicht (50, 66) eine vorgefertigte, einseitig beschichtete Prepreg-Schichtanordnung (56, 72) ausbilden.

9. Elektrische Steckbuchse nach Anspruch 8, **dadurch gekennzeichnet, dass** die vorgefertigte, einseitig beschichtete Leiterplatte (48, 64), die vorgefertigte, einseitig beschichtete Prepreg-Schichtanordnung (56, 72) und die Stabilisierungsschicht (32) aufeinandergestapelt und unter Wärmezufuhr miteinander verpresst sind.

10. Elektrische Steckbuchse nach einem der Ansprüche 1 bis 7, **dadurch gekennzeichnet, dass** die äußere Leiterbahnschicht (96, 108), die Trägerschicht (92, 104) und die innere Leiterbahnschicht (98, 112) der mindestens einen Schichtanordnung (88, 90) eine vorgefertigte, beidseitig beschichtete Leiterplatte (100, 114) ausbilden.

11. Elektrische Steckbuchse nach Anspruch 10, **dadurch gekennzeichnet, dass** die vorgefertigte, beidseitig beschichtete Leiterplatte (100, 114), mindestens eine unbeschichtete Prepreg-Schicht (102, 116) und die Stabilisierungsschicht (92) aufeinandergestapelt und unter Wärmezufuhr miteinander verpresst sind.

## Claims

1. Electrical plug socket having a housing (12) which comprises a plug compartment (20) for the insertion of a connection plug, wherein arranged in the housing (12) is a contact module (24) having a pressed multi-layer circuit board arrangement (26, 76), fixed to which are contact elements (28) that are contactable by associated plug contacts of the connection plug, and wherein the pressed multi-layer circuit board arrangement (26, 76) comprises a dielectric stabilization layer (32, 82) and arranged above and/or below the stabilization layer (32, 82) is a layer arrangement (38, 40, 88, 90) having a dielectric carrier layer (42, 58, 92, 104) which is positioned between an outer conductor track layer (46, 62, 96, 108) and an inner conductor track layer (54, 70, 98, 112), wherein the layer arrangement (38, 40, 88, 90) forms at least one plate capacitor (73, 74, 103, 118), **characterized in that** the carrier layer (42, 58, 92, 104) of the layer arrangement (38, 40, 88, 90) comprises a fiber-reinforced resin that has already been cured before the pressing of the multi-layer circuit board arrangement (26, 76) and arranged between the layer arrangement (38, 40, 88, 90) and the stabilization layer (32, 82) is at least one prepreg layer (50, 66, 102, 116) for fixing the layer arrangement (38, 40, 88, 90) to the stabilization layer (32, 82).

2. Electrical plug socket in accordance with Claim 1, **characterized in that** the stabilization layer (32, 82) comprises a fiber-reinforced resin that has already been cured before the pressing of the multi-layer circuit board arrangement (26, 76).

3. Electrical plug socket in accordance with Claim 2, **characterized in that** the stabilization layer (32, 82) comprises a fiber-reinforced epoxy resin that has already been cured before the pressing of the multi-layer circuit board arrangement (26, 76), in particular a glass fiber-reinforced epoxy resin that has already been cured before the pressing of the multi-layer circuit board arrangement (26, 76).

4. Electrical plug socket in accordance with Claim 1, 2, or 3, **characterized in that** the stabilization layer (32, 82) has a material thickness of at least 75 µm, in particular a material thickness of 75 µm to 1.2 mm.

5. Electrical plug socket in accordance with any one of the preceding Claims, **characterized in that** the carrier layer (42, 58, 92, 104) of the at least one layer arrangement (38, 40, 88, 90) comprises a fiber-reinforced epoxy resin that has already been cured before the pressing of the multi-layer circuit board arrangement (26, 76), in particular a glass fiber-reinforced epoxy resin that has already been cured before the pressing of them multi-layer circuit board arrangement (26, 76).

6. Electrical plug socket in accordance with any one of the preceding Claims, **characterized in that** the carrier layer (42, 58, 92, 104) of the at least one layer arrangement (38, 40, 88, 90) has a material thickness of at least 75 µm, in particular a material thickness of 75 µm to 1.2 mm.

7. Electrical plug socket in accordance with any one of the preceding Claims, **characterized in that** the at least one prepreg layer (50, 66, 102, 116), after the pressing of the multi-layer circuit board arrangement (26, 76), has a material thickness of at least 40 µm, in particular a material thickness of 40 µm to 180 µm

8. Electrical plug socket in accordance with any one of the preceding Claims, **characterized in that** the outer conductor track layer (46, 62) and the carrier layer (42, 58) of the at least one layer arrangement (38, 40) together form a prefabricated circuit board (48, 64) that is coated on one side, and **in that** the inner conductor track layer (54, 70) of the at least one layer arrangement (38, 40) and a prepreg layer (50, 66) abutting the inner conductor track layer (54, 70) form a prefabricated prepreg layer arrangement (56, 72) that is coated on one side.

9. Electrical plug socket in accordance with Claim 8, **characterized in that** the prefabricated circuit board (48, 64) that is coated on one side, the prefabricated prepreg layer arrangement (56, 72) that is coated on one side, and the stabilization layer (32) are stacked on each other and are pressed together while supplying heat.

10. Electrical plug socket in accordance with any one of Claims 1 to 7, **characterized in that** the outer conductor track layer (96, 108), the carrier layer (92, 104), and the inner conductor track layer (98, 112) of the at least one layer arrangement (88, 90) form a prefabricated circuit board (100, 114) that is coated on both sides.

11. Electrical plug socket in accordance with Claim 10, **characterized in that** the prefabricated circuit board (100, 114) that is coated on both sides, at least one uncoated prepreg layer (102, 116), and the stabilization layer (92) are stacked on each other and are pressed together while supplying heat.

## Revendications

1. Fiche femelle électrique avec un boîtier (12), qui présente une cavité de fiche mâle (20) pour l'introduction d'une fiche mâle de connexion, dans laquelle un module de contact (24) est disposé dans le boîtier (12) avec un ensemble de cartes de circuit imprimé multicouche (26, 76) comprimé, sur lequel des éléments de contact (28) sont fixés, qui peuvent être mis en contact par des contacts à fiche associés de la fiche mâle de connexion, et dans laquelle l'ensemble de cartes de circuit imprimé multicouche (26, 76) comprimé présente une couche de stabilisation (32, 82) diélectrique et un ensemble de couches (38, 40, 88, 90) est positionné au-dessus et/ou au-dessous de la couche de stabilisation (32, 82) avec une couche de support (42, 58, 92, 104) diélectrique, qui est positionnée entre une couche de pistes conductrices extérieure (46, 62, 96, 108) et une couche de pistes conductrices intérieure (54, 70, 98, 112), dans laquelle l'ensemble de couches (38, 40, 88, 90) réalise au moins un condensateur à plaques (73, 74, 103, 118), **caractérisée en ce que** la couche de support (42, 58, 92, 104) de l'ensemble de couches (38, 40, 88, 90) présente une résine renforcée par des fibres déjà durcie avant la compression de l'ensemble de cartes de circuit imprimé multicouche (26, 76) et au moins une couche de préimprégné (50, 66, 102, 116) est disposée entre l'ensemble de couches (38, 40, 88, 90) et la couche de stabilisation (32, 82) pour la fixation de l'ensemble de couches (38, 40, 88, 90) sur la couche de stabilisation (32, 82).

2. Fiche femelle électrique selon la revendication 1, **caractérisée en ce que** la couche de stabilisation (32, 82) présente une résine renforcée par des fibres déjà durcie avant la compression de l'ensemble de cartes de circuit imprimé multicouche (26, 76).

3. Fiche femelle électrique selon la revendication 2, **caractérisée en ce que** la couche de stabilisation (32, 82) présente une résine époxyde renforcée par des fibres déjà durcie avant la compression de l'ensemble de cartes de circuit imprimé multicouche (26, 76), en particulier une résine époxyde renforcée par des fibres de verre déjà durcie avant la compression de l'ensemble de cartes de circuit imprimé multicouche (26, 76).

4. Fiche femelle électrique selon la revendication 1, 2 ou 3, **caractérisée en ce que** la couche de stabilisation (32, 82) présente une épaisseur de matériau d'au moins 75 µm, en particulier une épaisseur de matériau de 75 µm à 1,2 mm.

5. Fiche femelle électrique selon l'une quelconque des revendications précédentes, **caractérisée en ce que** la couche de support (42, 58, 92, 104) de l'au moins un ensemble de couches (38, 40, 88, 90) présente une résine époxyde renforcée par des fibres déjà durcie avant la compression de l'ensemble de cartes de circuit imprimé multicouche (26, 76), en particulier une résine époxyde renforcée par des fibres de verre déjà durcie avant la compression de l'ensemble de cartes de circuit imprimé multicouche (26, 76).

6. Fiche femelle électrique selon l'une quelconque des revendications précédentes, **caractérisée en ce que** la couche de support (42, 58, 92, 104) de l'au moins un ensemble de couches (38, 40, 88, 90) présente une épaisseur de matériau d'au moins 75 µm, en particulier une épaisseur de matériau de 75 µm à 1,2 mm.

7. Fiche femelle électrique selon l'une quelconque des revendications précédentes, **caractérisée en ce que** l'au moins une couche de préimprégné (50, 66, 102, 116) présente après la compression de l'ensemble de cartes de circuit imprimé multicouche (26, 76) une épaisseur de matériau d'au moins 40 µm, en particulier une épaisseur de matériau de 40 µm à 180 µm.

8. Fiche femelle électrique selon l'une quelconque des revendications précédentes, **caractérisée en ce que** la couche de pistes conductrices extérieure (46, 62) et la couche de support (42, 58) de l'au moins un ensemble de couches (38, 40) réalisent conjointement une carte de circuits imprimés (48, 64) préfabriquée, revêtue d'un côté, et que la couche de pistes conductrices intérieure (54, 70) de l'au moins un ensemble de couches (38, 40) et une couche de préimprégné (50, 66) s'appliquant contre la couche de pistes conductrices intérieure (54, 70) réalisent un ensemble de couches de préimprégné (56, 72) préfabriqué, revêtu d'un côté.

9. Fiche femelle électrique selon la revendication 8, **caractérisée en ce que** la carte de circuits imprimés (48, 64) préfabriquée, revêtue d'un côté, l'ensemble de couches de préimprégné (56, 72) préfabriqué, revêtu d'un côté et la couche de stabilisation (32) sont empilées les unes sur les autres et compressées les unes avec les autres sous apport de chaleur.

10. Fiche femelle électrique selon l'une quelconque des revendications 1 à 7, **caractérisée en ce que** la couche de pistes conductrices extérieure (96, 108), la couche de support (92, 104) et la couche de pistes conductrices intérieure (98, 112) de l'au moins un ensemble de couches (88, 90) réalisent une carte de circuits imprimés (100, 114) préfabriquée, revêtue des deux côtés.

11. Fiche femelle électrique selon la revendication 10, **caractérisée en ce que** la carte de circuits imprimés (100, 114) préfabriquée, revêtue des deux côtés, au moins une couche de préimprégné (102, 116) non revêtue et la couche de stabilisation (92) sont empilées les unes sur les autres et compressées les unes avec les autres sous apport de chaleur.
